Europäisches Patentamt

European Patent Office

Office européen des brevets

(19)

(11) Publication number: 0 316 042
A1

(12) EUROPEAN PATENT APPLICATION

(21) Application number: 88202487.0

(22) Date of filing: 08.11.88

(51) Int. Cl.4: H01L 39/24 , C04B 35/00

(30) Priority: 12.11.87 NL 8702702

(43) Date of publication of application:
17.05.89 Bulletin 89/20

(84) Designated Contracting States:
AT CH DE ES FR GB IT LI NL SE

(71) Applicant: N.V. Philips' Gloeilampenfabrieken
Groenewoudseweg 1
NL-5621 BA Eindhoven(NL)

(72) Inventor: Severin, Jan Willem
c/o INT. OCTROOIBUREAU B.V. Prof.
Holstlaan 6
NL-5656 AA Eindhoven(NL)
Inventor: de With, Gijsbertus
c/o INT. OCTROOIBUREAU B.V. Prof.
Holstlaan 6
NL-5656 AA Eindhoven(NL)
Inventor: van Hal, Henricus Albertus Maria
c/o INT. OCTROOIBUREAU B.V. Prof.
Holstlaan 6
NL-5656 AA Eindhoven(NL)

(74) Representative: Pennings, Johannes et al
Internationaal Octrooibureau B.V. Prof.
Holstlaan 6
NL-5656 AA Eindhoven(NL)

(54) Method of manufacturing a superconducting body.

(57) A method of manufacturing a superconducting body from an oxidic superconducting material having a high density is characterized in that the superconducting oxidic material or starting materials thereof is/are mixed with an oxide of silver and the mixture is subsequently dense-sintered at a raised pressure. The material manufactured in accordance with the invention has a high critical current density, a large mechanical strength and a small sensitivity to moisture, while retaining a high critical temperature.

## Method of manufacturing a superconducting body

The invention relates to a method of manufacturing a superconducting body frp, an oxidic superconducting material.

The invention also relates to a superconducting body of an oxidic superconducting material having the composition $YBa_2Cu_3O_{7-\alpha-\delta}F_\alpha$, wherein $\alpha$ has a value of from 0 to 1 and $\delta$ has a value of from 0.1 to 0.5.

A method of preparing $YBa_2Cu_3O_{7-\delta}$ is described by P.M. Grant a.o. in Physical Review B, 35 , (13), pp. 7242-7244 (1987). The starting materials for the superconducting compound are $Y_2O_3$, $BaCo_3$ and $CuO$. These materials are mixed in powder form, heated in oxygen, ground and reheated. The powdery material thus formed is pressed into pellets and sintered in air at a temperature of 1.000° C. Subsequently, the pellets are slowly cooled to room temperature. Experimentally it has been established that when cooling is carried out too rapidly or in an inert atmosphere, for example argon, this results in a loss of superconducting behaviour of the material obtained.

Such a method is also described by R.J. Cava a.o., in Physical Review Letters, 58 (16), pp. 1676-1679 (1987). After sintering the pellets are cooled in an oxygen atmosphere and, preferably, subjected to an aftertreatment in an oxygen atmosphere at a higher temperature. The oxygen content of the superconducting material, and consequently also the superconducting behaviour, largely depend on the conditions during the synthesis. Although $YBa_2Cu_3O_{7-\delta}$ material can be described as an oxygen-defect layered perovskite material, the quantity of oxygen in the crystal lattice becomes too small when no additional measures are taken, leading to the formation of a tetragonal instead of an orthorhombic lattice, thereby losing superconductive behaviour at the desired high temperature, for example in liquid nitrogen.

In experiments which have led to the invention it has been established that superconducting materials which are manufactured in accordance with the method described hereinbefore exhibit a low density and contain many microcracks. This may be the reason that the maximum permissible current density in these superconducting materials has an unfavourably low value. In an attempt to improve this situation the said materials have been sintered at a raised pressure by means of uniaxial pressing. Then it was found that on cooling to a temperature of 4 K the materials thus manufactured did still not superconduct. An alternative method of preventing microcracks is the use of a fine powder, having a grain size smaller than 1μm, for the

sintering process. Also in this case it has been established that at temperatures over the boiling point of nitrogen no superconductivity occurs.

Experiments conducted out on thin layers of superconducting materials have shown that the maximum permissible current density can considerably exceed the current density observed in bulk material so far. Possibly, this can be attributed to a higher density and a high degree of orientation of the crystallites in such thin layers. At a layer thickness up to approximately 1μm apparently sufficient oxygen penetrates into the layer during annealing to obtain the desired composition. A method of manufacturing thin layers from $(La, Sr)_2CuO_4$ and $YBa_2Cu_3O_{7-\delta}$ comprising an aftertreat in oxygen of the layers is described by R.B. Laibowitz a.o., in Physical Review B, 35 (16), pp. 8821-8823 (1987).

It is an object of the invention to provide a method of manufacturing a superconducting body from an oxidic superconducting material, in which both a high density and a suitable superconducting behaviour are attained, so that a material is provided having a high permissible current density and an improved mechanical strength without being limited to the manufacture of thin layers. The sensitivity to moisture of these materials can also be reduced by the absence of microcracks.

This object is achieved in accordance with the invention by a method which is characterized in that the superconducting oxidic material or starting materials thereof is/are mixed with an oxide of silver, which mixture is subsequently dense-sintered at a raised pressure.

Sintering at a raised pressure can be carried out, for example, by hot uniaxial pressing or hot isostatic pressing, for example at a pressure of 100 MPa and a temperature of from 850° to 900° C.

An oxidic superconducting material which can be used in the method in accordance with the invention is $(La, Sr)_2CuO_4$, wherein Sr can be substituted by Ba. In a preferred embodiment of the method in accordance with the invention the oxidic superconducting material consists of $YBa_2Cu_3O_{7-\alpha-\delta}F_\alpha$, wherein $\alpha$ has a value of from 0 to 1 and wherein $\delta$ has a value of from 0.1 to 0.5. $YBa_2Cu_3O_{7-\delta}$ has a value of $T_c$ of approximately 90 K. Oxygen may be partly substituted by fluorine, for example up to 1 atom in the compositional formula indicated, which leads to an increase of $T_c$. Further, Y may be substituted by one or more rare earth metals and Ba by another alkaline earth metal, for example Sr.

The invention is based on the decomposition at a raised temperature of the silver oxide in silver and oxygen, such that an oxygen source is present in the superconducting material in a finely dispersed form. The silver formed is one of the few materials which do not disturb superconducting behaviour and, moreover, it brings about an improved oxygen diffusion in the material.

For example $Ag_2O$ can be used as an oxide of silver, but the method in accordance with the invention is most effective if silver peroxide, AgO, is used.

For a noticeable improvement of the result the quantity of silver peroxide should efficaciously amount to an least 2% by weight.

Efficaciously, the quantity of silver peroxide amounts to maximally 25% by weight because larger amounts do not lead to a further improvement of the result.

In a preferred embodiment of the method in accordance with the invention the quantity of silver peroxide is maximally 12% by weight.

The object of manufacturing a superconducting body from a material having a high permissible current density and an improved mechanical strength is achieved in accordance with the invention in that the superconducting body contains finely dispersed silver particles and in that the density of the superconducting body is at least 95% of the theoretical value. The theoretical density of a material is calculated on the basis of the dimensions of the crystal lattices of the component parts of the material, in this case $YBa_2Cu_3O_{7-\alpha-\delta}F_\alpha$ and Ag.

The invention will now be explained in greater detail by means of an exemplary embodiment.

### Example.

$Y_2O_3$, $BaCO_3$ and CuO are mixed in stoichiometric quantities and heated in oxygen to $900°$ C for 4 hours, after which the powder obtained is ground and reheated to $950°$ C for 4 hours.

The intermediate product obtained (90% by weight) is mixed with AgO (10% by weight) and densified for 1 hour at $875°$ C by means of hot uniaxial pressing at a pressure of 100 MPa.

The superconducting material thus manufactured has approximately the composition $YBa_2Cu_3O_{6.7}$ and has an electrical resistance of 0 at a temperature of 90 K. The density amounts to more than 95% of the theoretical value.

### Claims

1. A method of manufacturing a superconducting body from an oxidic superconducting material, characterized in that the superconducting oxidic material or starting materials thereof is/are mixed with an oxide of silver, which mixture is subsequently dense-sintered at a raised pressure.

2. A method as claimed in claim 1, characterized in that the oxidic superconducting material consists of $YBa_2Cu_3O_{7-\delta}$ in which Y may be partly replaced by a rare earth metal, barium may be partly replaced, by another alkaline earth metal such as strontium and oxygen may be partly replaced by fluorine.

3. A method as claimed in Claim 2, characterized in that the oxidic superconducting material consists of $YBa_2Cu_3O_{7-\alpha-\delta}F_\alpha$, wherein $\alpha$ has a value of from 0 to 1 and wherein $\delta$ has a value of from 0.1 to 0.5.

4. A method as claimed in Claim 1 to 3, characterized in that silver peroxide, AgO, is used as the oxide of silver.

5. A method as claimed in Claim 4, characterized in that the quantity of silver peroxide is at least 2% by weight.

6. A method as claimed in Claim 5, characterized in that the quantity of silver peroxide is maximally 25% by weight.

7. A method as claimed in Claim 6, characterized in that the quantity of silver peroxide is maximally 12% by weight.

8. A superconducting body of an oxidic superconducting material having the composition $YBa_2Cu_3O_{7-\alpha-\delta}F_\alpha$, wherein $\alpha$ has a value of from 0 to 1 and wherein $\delta$ has a value of from 0.1 to 0.5, characterized in that the superconducting body contains finely dispersed silver particles and that the density of the superconducting body is at least 95% of the theoretical value.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JAPANESE JOURNAL OF APPLIED PHYSICS, vol. 26, no. 5, May 1987, pages L834-L835; Y. SAITO et al.: "Composition dependence of superconductivity in $(Ba0.1La1.9)AgxCu1-xO4-y$ system" * Page L834, column 1, paragraph 3 * | 1 | H 01 L 39/24 C 04 B 35/00 |
| X | ADVANCED CERAMIC MATERIALS- CERAMIC SUPERCONDUCTORS, vol. 2, no. 3B, July 1987, pages 388-400, ACerS, Westerville, OH, US; R.W. McCALLUM et al.: "Problems in the productions of $YBa2Cu3Ox$ superconducting wire" * page 391, paragraph 2 * | 1 | |
| A | PHYSICAL REVIEW LETTERS, vol. 58, no. 24, 15th June 1987, pages 2579-2581, The American Physical Society; S.R. OVSHINSKY et al.: "Superconductivity at 155 K" * Abstract * | 1 | |
| A | JAPANESE JOURNAL OF APPLIED PHYSICS, vol. 26, no. 5, part 2, May 1987, pages L704-L705, Tokyo, JP; S. TSURUMI et al.: "High-Tc superconductivities of $(Y1-xYbx)2Ba4Cu6O14+y(0<y<2.5)$" * Abstract * | 2,8 | |
| A | JAPANESE JOURNAL OF APPLIED PHYSICS, vol. 26, no. 5, May 1987, pages L706-L708; T. WADA et al.: "Substitution effect of Sr for Ba of high-Tc superconducting $YBa2Cu3O7-y$ ceramics" * Abstract * | 2 | |

TECHNICAL FIELDS SEARCHED (Int. Cl.4)

H 01 L 39

The present search report has been drawn up for all claims

| Place of search | Date of completion of the search | Examiner |
|---|---|---|
| THE HAGUE | 08-02-1989 | PELSERS L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P0401)